# EUROPEAN PATENT APPLICATION

(11) **EP 1 577 948 A1**
(43) Date of publication of application: **21.09.2005**
(21) Application number: 04006259.8
(22) Date of filing: 16.03.2004
(51) Int. Cl.: H01L 25/065, H01L 23/48

(54) **Stacked microelectric module with vertical interconnect vias**

(71) Applicant: Irvine Sensors Corp., Costa Mesa, CA 92626 (US)
(72) Inventor: Ozguz, Volkan H., Aliso Viejo CA 92656 (US); Pepe, Angel A., Rancho Palos Verdes CA 92705 (US); Yamaguchi, James, Laguna Niguel CA 92677 (US); Camien, Andrew, Costa Mesa CA 92626 (US); Albert, Douglas M., Yorba Linda CA 92886 (US)
(74) Representative: Viering, Jentschura & Partner

(57) **Abstract**

A stackable layer and stacked multilayer module are disclosed. Individual integrated circuit die are tested and processed at the wafer level to create vertical area interconnect vias for the routing of electrical signals from the active surface of the die to the inactive surface. Vias are formed at predefined locations on each die on the wafer. The wafer is passivated and the vias are filled with a conductive material. The bond pads on the die are exposed and a metalization reroute from the user-selected bond pads and vias is applied. The inactive surface of the wafer may be back thinned if desired. The wafer is then segmented to form thin, stackable layers that can be stacked and vertically electrically interconnected using the conductive vias, forming high-density electronic modules which may, in turn, be further stacked and interconnected to form larger more complex stacks.

## Description

The disclosed invention relates generally to high-density, stacked electronic modules. Specifically, the invention relates to stacked integrated circuit die that are interconnected using vertical area vias.

Industry continues to seek devices that allow high-density electronic circuitry to occupy a very small space. Satellites, space applications, military weaponry and surveillance, and consumer electronics all require ever-smaller electronic circuitry. It has been determined that stacking layers of electronic circuitry and vertically interconnecting the layers provides a significant increase in circuit density per unit area. Examples of related three-dimensional stacking inventions are disclosed in patents issued to common assignee, Irvine Sensors Corp. U. S. Patent No. 6,560109, U. S. Patent No. 4,525,921, and U. S. Patent No. 4,646,128, each of which is incorporated herein by reference.

High-speed electronic applications operating in the gigahertz range create unique circuit design concerns with respect to capacitance, inductance and "time of flight" for electron travel. Shorter lead lengths within a high-speed circuit help minimize these design concerns. It has been determined that stacking of individual, unpackaged, integrated circuit die allows for a very small form factor, while achieving ultra-high circuit density and minimal lead lengths. But stacking of individual circuit die undesirably includes yield problems when a stack includes a failed layer, as well as complications related to interfacing, wire bonding and/or side-bussing of stacked integrated circuit die. Additionally, wirebonding interface interconnects creates longer lead lengths with associated problems of cross talk and electron time of flight. Side-bus interconnects on stacked integrated circuits are difficult to produce and the entire stack cannot be used if a single layer in the stack fails or is damaged during the manufacturing process but before final assembly.

Therefore, a need exists in the art which allows for the efficient, scalable stacking of integrated circuit die which reduces yield problems, manufacturing concerns and problems associated with wire bonding, side bussing and unnecessary lead lengths.

### SUMMARY OF THE INVENTION

The present invention includes layers of individual, pretested die that are unpackaged. One or more vertical interconnect vias are formed on individual integrated circuit die at the wafer level to allow the subsequent interconnect of the die when they are stacked.

The surface of the wafer is passivated with a suitable insulative material and the vias filled with a conductive material. The die's individual bond pads are exposed through the passivation layer at the wafer level. The desired electrically conductive traces between the exposed bond pads and/or interconnect vias are applied the wafer level using well-established processes. The inactive side of the wafer may be back thinned if desired using conventional thinning techniques.

The individual die or array of die are then cut from the wafers and are bonded together and electrically interconnected at the predetermined vias and bond pads so as to form "ministacks" comprising two to four layers. Solder reflow, if appropriate is performed to provide electrical connection of the solder at the via bond interface. Alternatively, a Z-conductive epoxy may be used to bond and interconnect the layers. The mini-stacks are tested and assembled into larger stacks which are ensured of containing functional layers. The inactive surface of the bottommost die in the stack may have vias or ball bonds which can be interconnected to external circuitry.

In this manner, very small form factor, multilayer stacks of individual circuit die are achieved with minimal lead lengths and without the use of external side bus conductors which are prone to damaged assembly or use.

Accordingly, it is an object of the invention to provide a stackable, integrated circuit die layer that is highly reliable and which may be interconnected to adjacent layers using vertical area vias. It is yet a further object of the invention to provide a multilayer module comprised of such layers that is low-cost, easy to test and assemble in high volume and which is not prone to damage due to lack of external conductive traces.

### BRIEF DESCRIPTION OF THE DRAWINGS

Figure 1 is a plan view of a wafer with individual integrated circuit die formed thereon.
Figure 2 shows an integrated circuit die of the present invention with active circuitry, bond pads and vias formed thereon.
Figure 3 illustrates a cross-section of a die of the present invention after application of a dielectric layer and conductive via fill.
Figure 4 is a cross-section of the die of Figure 3 after exposure of the bond pad and electrical interconnection to the via.
Figure 5 shows two of the layers of the present invention in an electrically interconnected ministack.

### DETAILED DESCRIPTION OF THE INVENTION

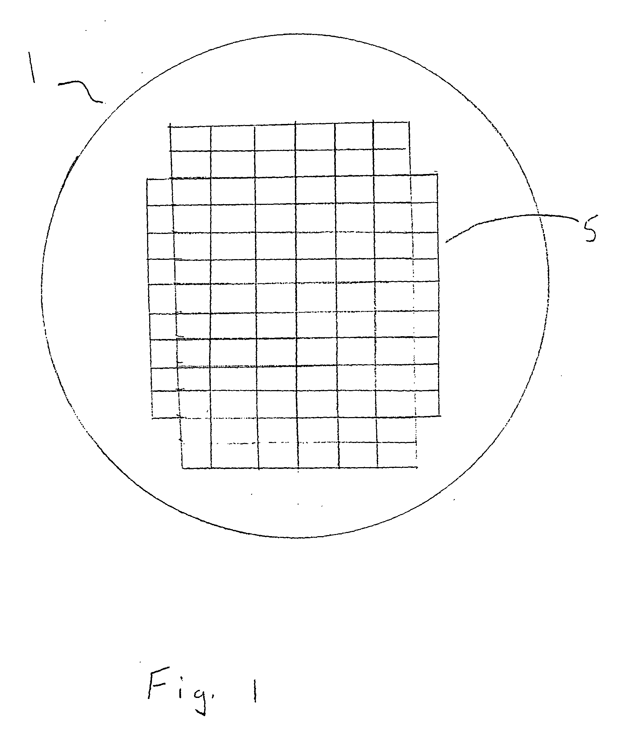

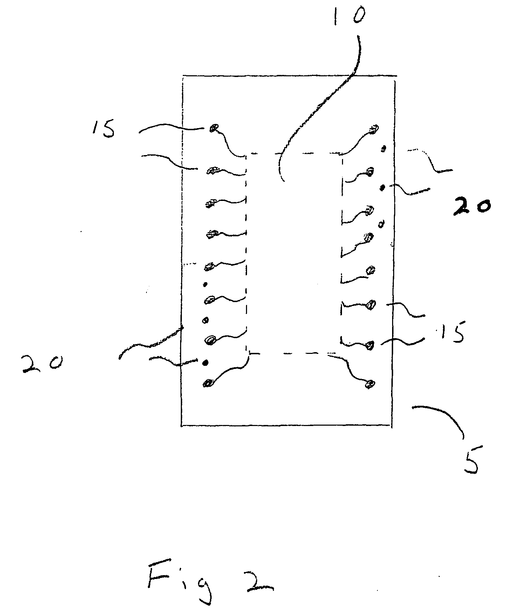

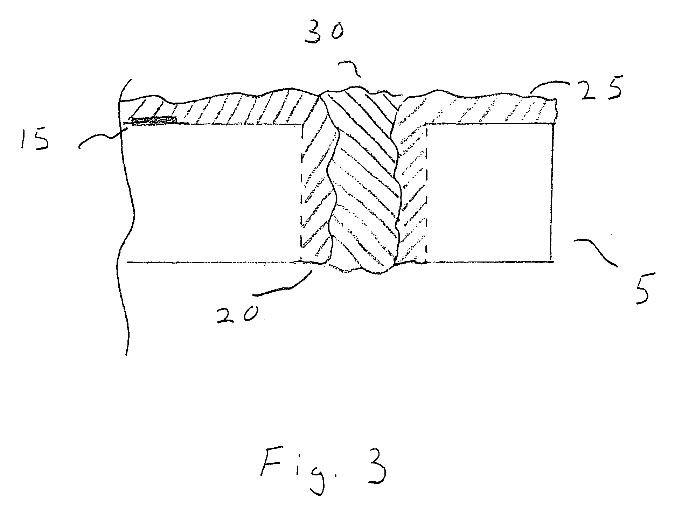

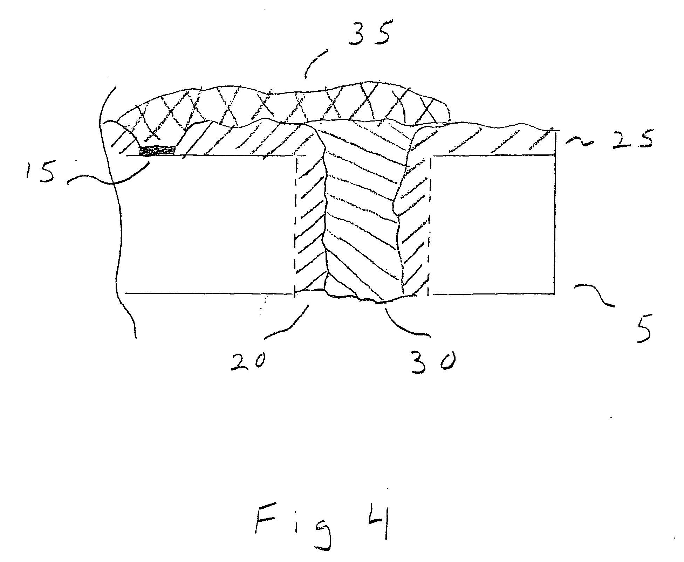

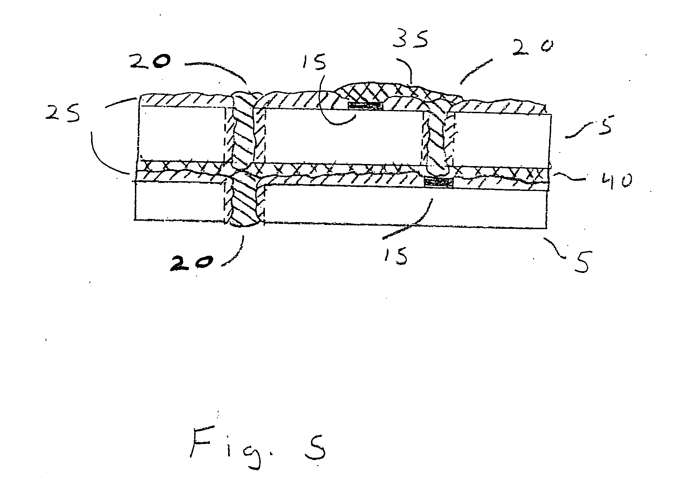

Turning now to the figures wherein like numerals designate like elements among the several views, Figure 1 shows a substrate such as a semiconductor wafer 1 with individual integrated circuit die 5 formed thereon. Figure 2 illustrates a more detailed view of individual die 5 of wafer 1, showing active circuitry 10 formed on die 5 and bonding pads 15 in electrical connection with active circuitry 10 for the routing of signals and power into and out of die 5.

In the invention's preferred embodiment, die 5 are tested at the wafer level to ensure the use of functional die within a stack and to identify functional die or sets of die (arrays) on the wafer. Additionally, because of the flexibility of the invention, both individual die or matching layers of equal sized die arrays on a wafer may be concurrently processed under the proposed invention.

Figure 1 further illustrates one or more vias 20 formed in each die 5 on wafer 1, at predetermined locations using industry standard dry etch or laser drill techniques, depending on the substrate material. Vias 20 are preferably 1-10 microns in diameter, extending completely through the substrate and may be formed using any process capable of creating high aspect ratio vias through the substrate.

Wafer passivation across all die on the wafer is performed to insulate circuitry and vias and to provide control of via capacitance. Figure 3 shows a cross-section of a portion of die 5 after the application of passivation layer 25 over via 20 and bond pad 15. In the preferred embodiment, atomic layer deposition (ALD) of a suitable dielectric layer such as silicon oxide or thermal oxide is used to ensure pinhole free coverage and because of ALD's ability to control dielectric thickness and related via capacitance.

As can be seen in Figure 3, an electrically conductive material 30 is then deposited in the vias, using, for instance, chemical vapor deposition (CVD) applied tungsten material to create an electrically conductive path through die 5.
The unique ability to vary the via formation, dielectric application and conductive via fill processes to control via diameter, dielectric thickness and via conductor diameter also allow the formation of various *in situ* passive components such as capacitors and resistors at and within the via sites and layer.

Turning now to Figure 4, predetermined vias 20 and bond pads 15 are exposed through passivation layer 25 on each die 5 on the wafer using conventional photolithographic techniques. Conductive metalization interconnects 35 are formed to interconnect desired filled vias and/or bond pads on the die using industry standard techniques

After wafer level via/bond pad interconnection, the inactive surface of the wafer optionally may be back-thinned (not shown) using mechanical or chemical techniques as are well known it the art such as grinding and/or remote atmospheric plasma etching.

Further testing to identify functional die or die arrays is preferably performed prior to segmenting of the wafer into individual die or die arrays.

Die 5 are segmented from wafer 1 prior to interconnection and stacking.

Turning to Figure 5, segmented die, preferably two to four die, are bonded together with an adhesive 40 and are electrically interconnected at predetermined vias and/or bond pads. Alternative preferred embodiments include using a Z-conductive epoxy such as ZTP8090FP available from AI Tech or a solder reflow technique to interconnect top layer vias and bond pads to lower layer bond pads or vias to form "ministacks" of die. If solder is used for interconnection, a suitable epoxy such as Epotek 353 from Epoxy Technology, is used for the bonding of the layers and the stack is reflowed to form the electrical connections. The use of a Z conductive epoxy desirably provides both the necessary adhesive and electrical connections for the layers.

In an alternative embodiment, micro-heat pipes may be inserted into the stack where in-stack power dissipation or stack thermal management is a concern.

As can be seen, under the present invention, a user may selectively process heterogeneous or homogenous integrated circuit die to form modular, scalable, building blocks of circuits. In this manner, each layer may be designed to form a building block of a desired circuit (e.g. op amp, ADC) that, in turn will be assembled into a final circuit of desired complexity. Alternatively, the ministack formed at this step may result in the final, desired circuit.

A further alternative preferred embodiment includes circuit design and die layout specifically providing for efficient bond pad and via locations and for the design of partial circuit "unit cell" layers, that can be assembled as layers to form complete circuits where the vias provide all unit cell interconnections necessary to realize full circuit functionality.

To maximize final stack yield, testing of the ministacks is performed prior to further incorporation into further assemblies. In an alternative preferred embodiment, the ministacks can be bonded and electrically interconnected together to form a stacked electronic module of greater circuit density.

It is important to note that the design and layout with respect to via formation and filling, bond pad exposure, interconnection metalization, and layer interconnection scheme must consider the layer-to-layer bond pad and via registration to ensure accurate and reliable bond pad and via interconnections when the layers are assembled.

By progressively testing and stacking die or die arrays, i.e. die to ministacks to final stacks, yield is greatly improved since a single failed layer or failed ministack is identified early in the manufacturing cycle under the present invention does not result in the loss of a completed multilayer stack.

From the foregoing description, it will be apparent the apparatus and method disclosed in this application will provide the significant functional benefits summarized in the introductory portion of the specification.

The following claims are intended not only to cover the specific embodiments disclosed, but also to cover the inventive concepts explained herein with the maximum breadth and comprehensiveness permitted by the prior art.

Many alterations and modifications may be made by those having ordinary skill in the art without departing from the spirit and scope of the invention. Therefore, it must be understood that the illustrated embodiment has been set forth only for the purposes of example and that it should not be taken as limiting the invention as defined by the following claims. For example, notwithstanding the fact the elements of a claim are set forth below in a certain combination, it must be expressly understood that the invention includes other combinations of fewer, more or different elements, which are disclosed above even though not claimed in such combinations.

The words used in this specification to describe the invention and its various embodiments are to be understood not only in the sense of their commonly defined meanings, but to include by special definition in this specification structure, material or acts beyond the scope of the commonly defined meanings. Thus, if an element can be understood in the context of this specification as including more than one meaning, then its use in a claim must be understood as being generic to all possible meanings supported by the specification and by the word itself.

The definitions of the words or elements of the following claims are, therefore, defined in this specification to include not only the combination of elements which are literally set forth, but all equivalent structure, material or acts for performing substantially the same function in substantially the same way to obtain substantially the same result. In this sense it is therefore contemplated that an equivalent substitution of two or more elements may be made for any one of the elements in the claims below or that a single element may be substituted for two or more elements in a claim. Although elements may be described above as acting in certain combinations and even initially claimed as such, it is to be expressly understood that one or more elements from a claimed combination can in some cases be excised from the combination and that the claimed combination may be directed to a sub-combination or variation of a sub-combination.

Insubstantial changes from the claimed subject matter as viewed by a person with ordinary skill in the art, now known or later devised, are expressly contemplated as being equivalently within the scope of the claims. Therefore, obvious substitutions now or later known to one with ordinary skill in the art are defined to be within the scope of the defined elements.

The claims are thus to be understood to include what is specifically illustrated and described above, what is conceptually equivalent, what can be obviously substituted and also what essentially incorporates the essential idea of the invention.

## Claims

1. A stackable layer comprised of:
A substrate having an active surface and an inactive surface, said active surface having active circuitry formed thereon, said active circuitry including at least one bond pad; means for electrically connecting said bond pad to a predefined location on said inactive surface.

2. The stackable layer of Claim 1 wherein said electrical connection means comprises at least one via defined in said substrate, said via including an electrically conductive material.

3. The stackable layer of Claim 2 wherein said electrically conductive material is a tungsten material.

4. A stackable layer comprised of:
A substrate having a first surface and a second surface, said first surface having at least one electrical connection point formed thereon, means for electrically connecting said electrical connection point to a predefined location on said inactive surface.

5. The stackable layer of claim 4 wherein said electrical connection means includes at least one via, said via including an electrically conductive material.

6. The stackable layer of Claim 5 wherein said electrically conductive material is a tungsten material.

7. A ministack comprised of:
A first substrate having an active surface and an inactive surface, said active surface having active circuitry formed thereon, said active circuitry including at least one bond pad; means for electrically connecting said bond pad to a predefined location on said inactive surface; a second substrate with an active surface with active circuitry formed thereon, said active circuitry of said second substrate including at least one electrical contact point; means for electrical interconnection of said predefined location on said first substrate with said at least one electrical contact point of said second substrate; said first substrate and said second substrate bonded together to form a stack.

8. The ministack of Claim 7 wherein said electrical contact point is a via, said via including an electrically conductive material.

9. The ministack of Claim 8 wherein said electrical contact point is a bond pad in electrical communication with said active circuitry of said second substrate.

10. The ministack of claim 8 wherein said first substrate electrical connection means includes at least one via defined in said first substrate, said via including an electrically conductive material.

11. The ministack of Claim 8 wherein said electrically conductive material is a tungsten material.

12. A stacked electronic module comprised of:
at least two ministacks of Claim 7; means for electrical interconnection of each of said at least two ministacks.

13. The stacked electronic module of Claim 12 wherein said electrical interconnection means comprises at least one via filled with an electrically conductive material defined in at least one of said at least two ministacks.

14. The stacked electronic module of Claim 13 wherein said electrically conductive material is a tungsten material.
